(19) Europäisches Patentamt
European Patent Office
Office européen des brevets

(11) **EP 3 845 507 B1**

(12) **EUROPEAN PATENT SPECIFICATION**

(45) Date of publication and mention
of the grant of the patent:
**01.03.2023 Bulletin 2023/09**

(21) Application number: **19938792.9**

(22) Date of filing: **04.11.2019**

(51) International Patent Classification (IPC):
*C04B 35/119* (2006.01)    *C04B 35/111* (2006.01)
*C04B 35/626* (2006.01)    *C04B 37/02* (2006.01)
*H05K 1/03* (2006.01)    *H01L 23/15* (2006.01)
*H01L 33/64* (2010.01)    *H01L 33/60* (2010.01)

(52) Cooperative Patent Classification (CPC):
**C04B 35/119; C04B 35/111; C04B 35/6262;**
**C04B 35/62635; C04B 35/62685; C04B 37/021;**
**H05K 1/0306;** C04B 2235/3206; C04B 2235/3208;
C04B 2235/3225; C04B 2235/3244;
C04B 2235/3418; C04B 2235/5436;
C04B 2235/5445; C04B 2235/5463;     (Cont.)

(86) International application number:
**PCT/CN2019/115243**

(87) International publication number:
**WO 2021/012448 (28.01.2021 Gazette 2021/04)**

(54) **ZIRCONIA-ALUMINA COMPOSITE CERAMIC SINTERED BODY, PREPARATION METHOD AND APPLICATION THEREOF**

GESINTERTER ZIRKONDIOXID-ALUMINIUMOXID KERAMISCHER VERBUNDKÖRPER, HERSTELLUNGSVERFAHREN UND VERWENDUNG DAVON

CORPS FRITTÉ COMPOSITE CÉRAMIQUE D'ALUMINE-ZIRCONE, PROCÉDÉ DE PRÉPARATION ET SON UTILISATION

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **23.07.2019 CN 201910670185**

(43) Date of publication of application:
**07.07.2021 Bulletin 2021/27**

(73) Proprietors:
• **Nanchong Three-Circle Electronics Co., Ltd.**
**Nanchong Sichuan 637100 (CN)**
• **Chaozhou Three-Circle (Group) Co., Ltd.**
**Chaozhou, Guangdong 515646 (CN)**

(72) Inventors:
• **HUANG, Xueyun**
**Nanchong, Sichuan 637100 (CN)**
• **JIANG, Nan**
**Nanchong, Sichuan 637100 (CN)**

(74) Representative: **Meyer, Thorsten**
**Meyer Patentanwaltskanzlei**
**Pfarrer-Schultes-Weg 14**
**89077 Ulm (DE)**

(56) References cited:
**EP-A1- 2 980 042**    **EP-A1- 3 315 476**
**WO-A1-2014/103465**    **CN-A- 104 755 445**
**CN-A- 105 906 331**    **CN-A- 105 948 723**
**CN-A- 110 330 317**    **DE-A1-102004 012 231**

**(Cont. next page)**

(52) Cooperative Patent Classification (CPC): (Cont.)
C04B 2235/6025; C04B 2235/96; C04B 2235/9607;
C04B 2237/54; C04B 2237/55; H01L 33/60;
H01L 33/641

**Description**

FIELD OF THE INVENTION

This invention relates to a zirconia-alumina composite ceramic sintered body, preparation method, and application thereof.

BACKGROUND OF THE INVENTION

The present invention relates to a high-temperature ceramic sintered body and a substrate made from the ceramic sintered body. The ceramic sintered body can be used as a substrate in power device packaging, such as high-reflectivity LED ceramic substrates and power module substrates. They can also be used as a metal-ceramic metallized substrate produced by DCB or AMB processes. The present invention belongs to the field of alumina ceramic composite performance improvement.

Patent document 1 (application number: CN 201080015347.3) discloses a sintered body, which comprises zirconia powder having an upper weight limit of 30 wt%; 80% of the zirconia powder is tetragonal zirconia. The sintered body also comprises 0.05 wt% - 0.5 wt% of magnesium oxide. Compared with previous ceramic substrates that contain alumina only, the substrate of patent document 1 has significantly increased mechanical strength and heat dissipation. Patent document 2 (application number: CN 201380056024.2) discloses the following: by adding 2 wt% - 15 wt% zirconia and 0.01 wt% - 1 wt% yttrium oxide to an alumina ceramic matrix, and by controlling alumina particle size at a range of 2-8 $\mu$m, the mechanical strength of the ceramic substrate can be increased. The thickness of the metal layer and the ceramic layer can be thus reduced, hence increasing the thermal conductivity of the metal-ceramic substrate. Patent document 3 (application number: DE 102004012231) discloses the following: by adding 2-9 wt% zirconia, 0.04-1 wt% yttrium oxide, and 0.04-1 wt% calcium oxide to an alumina ceramic matrix, the mechanical strength of the ceramic can be increased. The thickness of the metal layer and the ceramic layer can be thus reduced, hence increasing the thermal conductivity of the metal-ceramic substrate. Patent document 4 (EP 3315476 A1) discloses a ceramic substrate comprising alumina crystals and zirconia crystals, wherein a mass ratio of A to B is from 89:11 to 93:7, where A is a mass of alumina, and B is a total mass of a stabiliser component, hafnia, and zirconia. An average crystal grain size of the alumina crystal is not less than 1.0 $\mu$m and not greater than 1.5 $\mu$m; an average crystal grain size of the zirconic crystals is not less than 0.3 $\mu$m and not greater than 0.5 $\mu$m. Patent document 5 (WO 2014/103465 A1) discloses an alumina substrate that contains 92-95 wt% of alumina, 4-6 wt% of partially yttria-stablised zirconia, 0.2-0.5 wt% of MgO, 0.05-0.2 wt% of CaO, and 0.4-1.0 wt% of silica. Patent document 6 (EP 2980042 A1) discloses a light-emitting element mounting substrate comprising an alumina sintered body, said alumina sintered body contains alumina crystal, zirconia crystal, and grain boundary phase.

In patent documents 1 and 3, $SiO_2$ and MgO are added to the matrix. They constitute a flux phase that promotes the densification of the ceramic sintered body. However, after the densification of the sintered body, the flux phase (particularly $SiO_2$) accumulates between the alumina grain boundary phase and the zirconia grain boundary phase. As a result, the strength between the grain boundaries is decreased and the mechanical strength of the sintered body is not at its optimal. The addition of the flux also increases the heterogeneity between the grains of the ceramic sintered body, decreases the phonon transmission rate, and eventually leads to decreased thermal conductivity. In patent document 2, the alumina particle size is controlled at 2-8 $\mu$m; at this grain size, the zirconia particle size distribution is between 0.7-2.5 $\mu$m. The large alumina grain size leads to decreased number of grain boundaries and increased sizes of defects, such as gas holes of the bulk phase. These factors eventually contribute to a relatively low mechanical strength of the ceramic matrix. In addition, due to the large alumina grain size, zirconia grains between the grain boundaries become lager, or the grains agglomerate to a serious extent, undermining the stability of tetragonal zirconia. As a result, during the fracture of the ceramic matrix, zirconia exerts less strengthening effect through phase transformation, the mechanical strength of the matrix is less than optimal.

SUMMARY OF THE INVENTION

The objective of the present invention is to overcome the deficiencies of the prior art and provide a zirconia-alumina composite ceramic sintered body. The sintered body has high mechanical strength and high thermal conductivity.

To achieve the aforementioned objective, the technical solution of the present invention is as follows: a zirconia-alumina composite ceramic sintered body, characterized in that the zirconia-alumina composite ceramic sintered body comprises the following components in percentage by mass: 5%-15% of a zirconium-containing compound, content thereof calculated with zirconia; 0.3%-1% of a yttrium-containing compound, content thereof calculated with yttrium oxide; 0.04%-0.8% of a silicon-containing compound, content thereof calculated with silicon oxide; 0.01%-0.03% of a calcium-containing compound, content thereof calculated with calcium oxide; 0-0.03% of a magnesium-containing compound, content thereof calculated with magnesium oxide; and the balance being alumina; the zirconium-containing compound comprises zirconia.

Regarding mechanical strength: tetragonal zirconia is present in alumina grains. During the fracture of the sintered body, the crack extends to the zirconia grain boundary, zirconia undergoes phase transition (tetragonal phase is transformed into monoclinic phase), which absorbs the potential energy of the crack and prevents crack propagation. As the amount of zirconia added increases, the degree of crack propagation prevention through phase transition increases, resulting in a further increase in mechanical strength. In the technical solution of the present invention, when zirconia content is the same, and with decreasing amounts of $SiO_2$, MgO, and CaO added, flux concentration at the grain boundary decreases, which further increases grain boundary strength. Thus, the mechanical strength of the ceramic sintered body can be increased without altering the amount of zirconia added.

Regarding thermal conductivity: with the addition of zirconia, the thermal conductivity of the composite ceramic sintered body decreases. This is because the thermal transmission in non-metallic materials is conducted by phonons (i.e., lattice resonance). A more consistent lattice spacing leads to a higher phonon transmission rate. As the lattice spacing of zirconia and alumina is not equal, the addition of zirconia leads to a decrease in phonon transmission rate, which leads to decreased thermal conductivity. By not altering the amount of zirconia while reducing the amount of MgO, CaO, and $SiO_2$ added, the thermal conductivity of the composite ceramic sintered body increases. The reason is that the flux in the sintered body is mostly accumulated between alumina or zirconia grain boundaries. The lattice spacing of the accumulation phase is significantly different from that of the main crystalline phase, which leads to a decrease in phonon transmission rate. Therefore, the thermal conductivity of the sintered body can be increased by reducing the quantity of the accumulation phase.

Regarding bonding strength: The bonding mechanism of the copper-clad substrate is that metal copper reacts with Al-OH bonds at the matrix surface at a temperature near its melting point to form an Al-O-Cu bond. Zr-OH bonds can also bond with metal copper. A small number of Zr-O-Cu bonds have a supplementary effect on bonding strength, but as the amount of $ZrO_2$ further increases, a gradual decrease in bonding strength is observed due to the different bonding strengths of Al-O-Cu and Zr-O-Cu.

Regarding dielectric strength: dielectric strength is defined by the threshold voltage required to puncture the substrate divided by the thickness of the substrate. For metals, the free-moving electrons in the bulk phase form currents. For alumina crystals, no internal free-moving electrons are present, the only mobile carrier is the cation. The smaller the cation radius, the faster the migration speed (for example, the presence of Na particles in the sample causes a decrease in dielectric strength). For the alumina matrix, oxygen vacancies between crystals mainly act as carriers to form current ($Al^{3+}$ migration). The main factors that determine the speed of oxygen vacancy migration are grain size (the number of grain boundaries, the migration of $Al^{3+}$ ions between grain boundaries is more difficult), the amount of flux impurity (magnesium and calcium atoms are small, so they migrate fast; the silica-lime glass phase in the matrix is amorphous, therefore no grain boundary is present to limit the migration speed), and the amount of zirconia (zirconium has a larger atomic radius, so it moves slower than $Al^{3+}$). These factors affect the dielectric strength.

Preferably, the zirconia-alumina composite ceramic sintered body comprises the following components in percentage by mass: 5%-10% of the zirconium-containing compound (content thereof calculated with zirconia), 0.3%-0.8% of the yttrium-containing compound (content thereof calculated with yttrium oxide), 0.4%-0.6% of the silicon-containing compound (content thereof calculated with silicon oxide), 0.01%-0.03% of the calcium-containing compound (content thereof calculated with calcium oxide), 0-0.03% of the magnesium-containing compound (content thereof calculated with magnesium oxide), and the balance being alumina.

In the present invention, by reducing the amount of $SiO_2$, MgO and CaO added, the homogeneity of $Al_2O_3$ grain boundaries can be improved, and the grain boundary strength and thermal conductivity of alumina can be increased. In the ZTA ceramic sintered body obtained through the formulation of the invention, the grain boundaries of alumina and zirconia are distributed adjacently, thereby restricting each other's grain sizes.

Preferably, the magnesium-containing compound is magnesium aluminum spinel.

Preferably, in the zirconia-alumina composite ceramic sintered body, an average particle size D50 of the zirconium-containing compound is (0.1-1.5) times an average particle size D50 of the alumina. When the difference between the average particle size of zirconia and the average particle size of alumina is too big, large gaps will appear in the crystal phases of different substances in the sintered body, hence reducing the mechanical strength of the product.

Preferably, in the zirconia-alumina composite ceramic sintered body, an average particle size D50 of the alumina is 0.8 $\mu$m-3 $\mu$m, a maximum particle size range of the alumina is 4 $\mu$m-10 $\mu$m.

More preferably, in the zirconia-alumina composite ceramic sintered body, an average particle size D50 of the alumina is 1.3 $\mu$m-2.5 $\mu$m, a maximum particle size range of the alumina is 4 $\mu$m-7 $\mu$m.

Preferably, in the zirconia-alumina composite ceramic sintered body, an average particle size D50 of zirconia is 0.2 $\mu$m-1.5 $\mu$m, a maximum particle size range of zirconia is 1.0 $\mu$m-2.5 $\mu$m.

More preferably, in the zirconia-alumina composite ceramic sintered body, an average particle size D50 of the zirconia is 0.4 $\mu$m-0.8 $\mu$m, a maximum particle size range of the zirconia is 1.2 $\mu$m-1.8 $\mu$m.

In the sintered body of the present invention, the $Al_2O_3$ matrix fluxed by $ZrO_2$ is densified by controlling the initial particle size and uniformity of dispersion of $ZrO_2$, allowing *in-situ* fluxing, during which the grains do not migrate. This technology can increase the mechanical strength and thermal conductivity of the alumina ceramic matrix. By reducing the average particle size and maximum particle size of $Al_2O_3$ in the sintered body, increasing the number of $Al_2O_3$ grain boundaries in the matrix, reducing the size of gas holes, and increasing the degree of dispersion of $ZrO_2$ in the matrix, the phase-transition-toughening effect of $ZrO_2$ in the matrix can be enhanced, thereby increasing the mechanical strength of the ceramic matrix.

The present invention also provides an alumina substrate comprising the zirconia-alumina composite ceramic sintered body.

Preferably, the present invention provides a ceramic substrate for copper cladding.

More preferably, the present invention provides an alumina substrate that can be used in DBC (direct bonding copper) metal-ceramic substrates.

The present invention also provides a method for preparing the alumina substrate, comprising the following steps:

(1) crushing raw material powder; pre-dispersing the raw material powder, excluding alumina, with one part of the alumina;
(2) calcinating the pre-dispersed powder of step 1 at 1300°C-1400°C for a holding time of 1-3 h, followed by crushing; then, adding the other part of the alumina for further mixing and dispersion to complete dispersion and mixing of the raw material powder;
(3) mixing the raw material powder obtained after the dispersion and mixing of step (2) with an organic binder and a dispersant;
(4) slurry degassing and aging;
(5) tape casting;
(6) sintering to obtain the alumina substrate.

In the preparation of the alumina substrate of the present invention, considering the different specific gravity of zirconia powder and alumina powder, the raw material powder of the zirconia-alumina composite ceramic substrate is dispersed in two steps: the zirconia powder and a part of the alumina powder are first dispersed; after low-temperature calcination, a certain bonding force is present between the $ZrO_2$ and $Al_2O_3$ powder in the ZTA pre-sintered body; then, the ZTA pre-sintered body is dispersed with the alumina powder. This process allows an increased degree of dispersion of $ZrO_2$ in ZTA, ZrO2 thus exhibits better fluxing ability, reducing the amount of $SiO_2$, MgO and CaO required.

Preferably, in steps (1) and (2), the parameters for pre-dispersion and mixing and dispersion are: dispersion time: 30-45 h, the particle size of the powder is controlled within the range of D50≤0.8 $\mu$m.

Preferably, in step (2), the parameters for low-temperature calcination are: sintering temperature: >1300°C, holding time: 1-3 h. The parameters for crushing are: ball milling time: 20-40 h, the particle size is controlled within the range of D50≤0.6 $\mu$m.

Preferably, in step (3), the parameters for mixing the raw material powder with the dispersant are: dispersion time: 30-45 h, the particle size is controlled within the range of D50≤0.6 $\mu$m. The parameters for mixing the raw material powder with the organic binder are: dispersion time: 5-15 h, viscosity after grinding: ≤ 1000 CPs.

Preferably, parameters for slurry degassing and aging are as follows. (1) slurry degassing: degassing pressure: -0.05 MPa - -0.1 MPa, stirring speed: 10-30 Hz, slurry temperature: 15-35°C, slurry viscosity: 1000-7000 Cps. (2) Parameters for blending the ZTA powder with the binder: aging time: 5-24 h, stirring speed: 0 - 3 Hz, slurry temperature is controlled at 25-30°C, slurry viscosity is controlled at 1000-7000 Cps.

Preferably, parameters for tape casting are: casting speed: 0.7-3 m/s; zone 1 temperature: 15-50 °C , zone 2 temperature: 40-70 °C , zone 3 temperature: 65-110°C, zone 1 wind speed: 0.2 -1.5 m/s, zone 2 wind speed: 0.8-5 cm/s, zone 3 wind speed: 0.5-5 m/s.

Preferably, parameters for sintering are: sintering temperature: 1400-1570°C, holding time: 0.5-4 h.

Also disclosed is a method for clapping the alumina substrate with copper, which comprises the following steps:

(1) Cutting a copper foil into a suitable size;
(2) Pre-oxidising the surface of the copper foil to increase the bonding activity on the copper foil surface;
(3) Cleaning and chemically treating the surface of the alumina substrate to increase the activity of -OH groups on the surface;
(4) Copper-cladding the first surface: placing a copper sheet on the surface of the substrate. Metal copper is bonded to the matrix surface in a reducing atmosphere furnace (the furnace temperature is controlled at near the critical melting point of copper);
(5) Copper-cladding the second surface: placing the treated copper foil on the other side of the substrate. Metal copper is bonded to the second matrix surface in a reducing atmosphere furnace (the furnace temperature is slightly lower than the copper-cladding temperature of the first surface).

Compared with the prior art, the beneficial effects of the present invention are:
In the zirconia-alumina composite ceramic sintered body of the present invention, by reducing flux content (MgO<500 ppm, CaO≤350 ppm, SiO2<8000 ppm), the impacts of the flux on grain boundary strength and phonon transmission rate can be reduced. The initial particle size and uniformity of dispersion of $ZrO_2$ are controlled, thereby allowing the densification of the $Al_2O_3$ matrix fluxed by $ZrO_2$ and allowing *in-situ* fluxing. The present invention increases the mechanical strength and thermal conductivity of the alumina ceramic matrix.

BRIEF DESCRIPTION OF DRAWINGS

Fig. 1 is an SEM image of the ZTA pre-sintered body of the present invention.
Fig. 2 is an SEM image of the ZTA sintered body of embodiment 22 of the present invention.

DETAILED DESCRIPTION OF EMBODIMENTS

To better illustrate the objectives, technical solutions, and beneficial effects of the present invention, the present invention will be further described below with reference to the accompanying drawings and detailed embodiments.
The present invention includes embodiments 1-15. The compositions of the sintered bodies of embodiments 1-15 and comparative example 1 (in wt%) are shown in Table 1.

Table 1- Compositions of Sintered Bodies of Embodiments 1-15

| Embodiments | Zirconia | Yttrium oxide | Silicon oxide | Calcium oxide | Magnesium oxide | Alumina |
|---|---|---|---|---|---|---|
| Embodiment 1 | 0.01 | 0 | 0.80 | 0 | 0.04 | 99.15 |
| Embodiment 2 | 0.5 | 0.30 | 0 | 0.02 | 0.04 | 99.14 |
| Embodiment 3 | 1.2 | 0.35 | 0.52 | 0.011 | 0.04 | 97.879 |
| Embodiment 4 | 3.5 | 0.40 | 0.60 | 0.024 | 0.05 | 95.426 |
| Embodiment 5 | 5.0 | 0.40 | 0.40 | 0.035 | 0.035 | 94.13 |
| Embodiment 6 | 5.8 | 0.45 | 0.04 | 0.03 | 0.03 | 93.65 |
| Embodiment 7 | 6.8 | 0.52 | 0.10 | 0.032 | 0.035 | 92.513 |
| Embodiment 8 | 7.2 | 0.45 | 0.20 | 0.018 | 0.01 | 92.122 |
| Embodiment 9 | 8.1 | 0.60 | 0.05 | 0.03 | 0.025 | 91.195 |
| Embodiment 10 | 9.3 | 0.62 | 0.01 | 0.03 | 0.025 | 90.015 |
| Embodiment 11 | 10.0 | 0.68 | 0 | 0.033 | 0.01 | 89.277 |
| Embodiment 12 | 13.2 | 0.80 | 0.56 | 0.005 | 0.015 | 86.42 |
| Embodiment 13 | 14.3 | 0.78 | 0.60 | 0.009 | 0 | 84.311 |
| Embodiment 14 | 15.0 | 1.20 | 0.08 | 0.01 | 0.02 | 83.69 |
| Embodiment 15 | 18.2 | 1.50 | 0.06 | 0.014 | 0.02 | 80.206 |
| Embodiment 16 | 20.0 | 1.75 | 0.39 | 0.022 | 0.02 | 77.818 |
| Embodiment 17 | 9.4 | 0.64 | 0.80 | 0.03 | 0.04 | 89.09 |
| Embodiment 18 | 9.4 | 0.64 | 0.50 | 0.025 | 0.03 | 89.405 |
| Embodiment 19 | 9.4 | 0.64 | 0.10 | 0.01 | 0.01 | 89.84 |
| Embodiment 20 | 9.4 | 0.64 | 0.01 | 0 | 0 | 89.95 |
| Comparative Example 1 | 0 | 0 | 0.01 | 0.03 | 0.03 | 99.93 |

Embodiments 1-5, 7, 10, 11, 17 and 20 are not subject-matter of claim 1. The preparation method comprises the following steps:

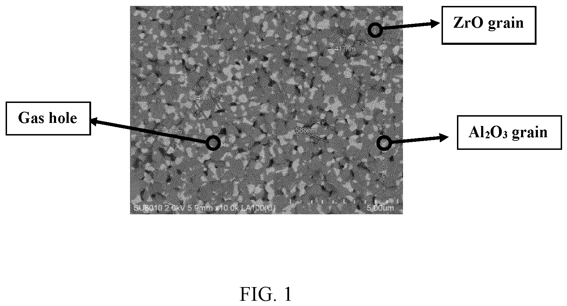

(1) crushing raw material powder; pre-dispersing the raw material powder (excluding alumina) with one part of the alumina, as shown in Fig. 1.

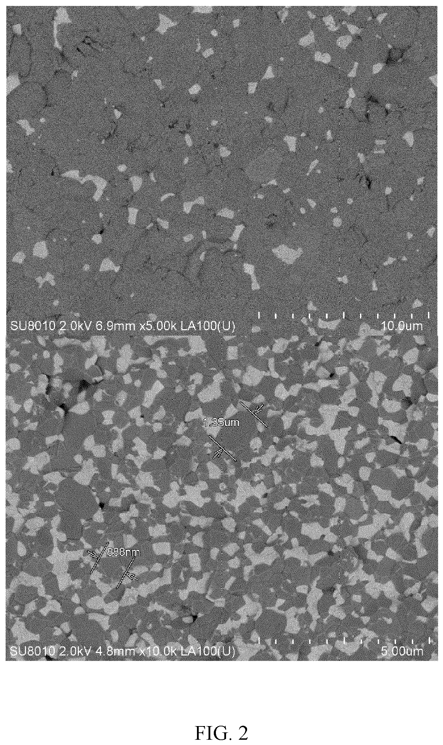

(2) Calcinating the pre-dispersed powder at a low temperature (please refer to Fig. 2), followed by crushing. Then, adding the other part of the alumina for further mixing and dispersion to complete dispersion and mixing part of the raw material powder. The parameters for pre-dispersion and mixing and dispersion are: dispersion time: 30-45 h, the particle size of the powder is controlled within the range of D50≤0.8 $\mu$m. The parameters for low-temperature calcination are: sintering temperature: 1300 °C -1400 °C , holding time: 1-3 h. The parameters for crushing are: ball milling time: 20-40 h, the particle size is controlled within the range of D50≤0.6 $\mu$m.

(3) Mixing the raw material powder obtained after the dispersion and mixing of step (2) with an organic binder and a dispersant. The parameters for mixing the raw material powder with the dispersant are: dispersion time: 30-45 h, the particle size is controlled within the range of D50≤0.6 $\mu$m. The parameters mixing the raw material powder with the organic binder are: dispersion time: 5-15 h, viscosity after grinding: ≤ 1000 CPs.

(4) Slurry degassing and aging. Parameters for slurry degassing: degassing pressure: -0.05 MPa - -0.1 MPa, stirring speed: 10-30 Hz, slurry temperature: 15-35 °C, slurry viscosity: 1000-7000 Cps. Parameters for blending the ZTA powder with the binder: aging time: 5-24h, stirring speed: 0-3 Hz, slurry temperature is controlled at 25-30 °C, slurry viscosity is controlled at 1000-7000 Cps.

(5) Tape casting. Casting speed: 0.7-3 m/s; zone 1 temperature: 15-50°C, zone 2 temperature: 40-70°C, zone 3 temperature: 65-110°C, zone 1 wind speed: 0.2 -1.5 m/s, zone 2 wind speed: 0.8-5 cm/s, zone 3 wind speed: 0.5-5 m/s.

(6) Sintering to obtain the alumina substrate. The temperature of the substrate testing: 1400-1570°C, holding time: 0.5-4 h.

The dielectric strength, thermal conductivity, and flexural strength of the ceramic substrate were respectively measured (the minimum value of each test group was recorded, the sintering temperature of the sample was 1450°C).

Dielectric strength can be determined by the method specified in national standard GBIT 18791-2002: placing the sample into the transformer oil; applying DC/AC voltage to the sample; the dielectric strength of the sample is obtained by gradually increasing the voltage until an electrical burn-through punctures the sample, causing the sample to lose its insulation properties.

Thermal conductivity can be determined by the method specified in national standard GBIT 5598-2015: the sample is a disc with a diameter d=10 mm; testing the sample and a standard sample of the same thickness in a laser flash thermal diffusion coefficient testing device at short time intervals to obtain the sample's thermal diffusivity $\alpha$ and specific heat capacity Cp. The bulk density of the sample is deduced via the Archimedes principle. The sample's thermal conductivity can be calculated according to the formula

$$\lambda = \alpha \cdot Cp \cdot \rho.$$

Flexural strength can be determined as follows: the sample is divided into rectangular sheets of l=40mm and b=24mm by laser scribing; scribing depth is 35-50% of the thickness of the sample. Measuring the thickness h of each sample with a micrometer. Placing the scribed surface on an electro-mechanical universal testing machine, span L=30 mm, roller diameter d=3 mm, the upper roller moves downwards at a speed of v=0.5 mm/min. The critical flexural load F of the sample is measured. The flexural strength of the sample is calculated according to the formula $\delta = 3FL/2bh^2$.

The results are shown in Table 2.

Table 2

| Embodiments | Flexural strength (MPa) | Thermal conductivity (W/m·K) | Dielectric strength (KV/mm) |
|---|---|---|---|
| Embodiment 1 | 351 | 29.1 | 16.2 |
| Embodiment 2 | 453 | 29 | 17.8 |
| Embodiment 3 | 488 | 28.7 | 18.2 |
| Embodiment 4 | 549 | 28.5 | 18.7 |
| Embodiment 5 | 524 | 28.2 | 19.3 |
| Embodiment 6 | 555 | 28 | 19.7 |

(continued)

| Embodiments | Flexural strength (MPa) | Thermal conductivity (W/m·K) | Dielectric strength (KV/mm) |
|---|---|---|---|
| Embodiment 7 | 597 | 27.6 | 20 |
| Embodiment 8 | 617 | 27.6 | 20.3 |
| Embodiment 9 | 603 | 27.4 | 21.9 |
| Embodiment 10 | 663 | 27.2 | 21.8 |
| Embodiment 11 | 691 | 27.3 | 22.1 |
| Embodiment 12 | 774 | 26.8 | 23.4 |
| Embodiment 13 | 793 | 26.4 | 24.9 |
| Embodiment 14 | 806 | 26.3 | 25.1 |
| Embodiment 15 | 859 | 25.5 | 26.7 |
| Embodiment 16 | 903 | 25 | 27.2 |
| Embodiment 17 | 556 | 27.2 | 19.2 |
| Embodiment 18 | 579 | 27.6 | 19.4 |
| Embodiment 19 | 585 | 27.9 | 19.9 |
| Embodiment 20 | 593 | 28.3 | 20.4 |
| Comparative Example | 311 | 31.1 | 15.5 |

Fig. 1 shows that zirconia and alumina in the ZTA pre-sintered body are uniformly dispersed. The average particle sizes D50 of the two are well controlled. As labelled in the figure, alumina particle sizes are 588 nm and 784 nm. Zirconia particle sizes are 417 nm and 708 nm, respectively.

It can be concluded from Table 2 that the addition of zirconia or increase in zirconia content greatly increases the flexural strength of the substrate, but at the same time leads to a decrease in thermal conductivity. It can be concluded from embodiments 17-20 that when zirconia content remains unchanged, and with decreasing amounts of $SiO_2$, MgO, and CaO added, flux concentration at the grain boundary decreases, which increases grain boundary strength and reduces phonon transmission rate. In other words, by not changing the amount of zirconia while reducing the amount of $SiO_2$, MgO, and CaO added, the mechanical strength and thermal conductivity of the ceramic sintered body can be increased. Table 2 also demonstrates that when zirconia content is too low, the flexural strength of the substrate is relatively low; when zirconia content is too high, thermal conductivity decreases. To employ the substrate in copper-cladding, the substrate needs to have a well-balanced flexural strength and thermal conductivity. Generally speaking, if the substrate has a flexural strength of above 500 MPa and a thermal conductivity of above 27 W/m·K, it could meet the requirements of various applications: for example, such a substrate can become a copper-clad ceramic substrate. This is an important reason why in the present application, the substrate preferably comprises 5% - 10% of a zirconium-containing compound (content thereof calculated with zirconia), 0.3% - 0.8% of a yttrium-containing compound (content thereof calculated with yttrium oxide), 0.4% - 0.6% of a silicon-containing compound (content thereof calculated with silicon oxide), 0.01% - 0.03% of a calcium-containing compound (content thereof calculated with calcium oxide), 0 - 0.03% of a magnesium-containing compound (content thereof calculated with magnesium oxide), and the balance being alumina.

The composition of embodiments 21-25 is the same as that of embodiment 16. Alumina and zirconia particle size distribution was controlled by grinding and dispersing alumina and zirconia powder. The other procedures were carried out according to the aforementioned processes and testing methods. It was difficult to control the particle size of the sintered substrate in the experiment, so the initial and final values are not included here. The data is shown in Table 3.

Table 3

| | Zirconia average particle size D50 (μm) | Alumina average particle size D50 (μm) | Flexural strength (MPa) | Thermal conductivity (W/m·K) |
|---|---|---|---|---|
| Embodiment 21 | 0.4 | 1.45 | 914 | 28.2 |

(continued)

| | Zirconia average particle size D50 (μm) | Alumina average particle size D50 (μm) | Flexural strength (MPa) | Thermal conductivity (W/m·K) |
| --- | --- | --- | --- | --- |
| Embodiment 22 | 0.7 | 1.38 | 931 | 27.9 |
| Embodiment 23 | 1.2 | 1.41 | 763 | 27.5 |
| Embodiment 24 | 0.2 | 0.8 | 847 | 27.4 |
| Embodiment 25 | 1.4 | 1 | 733 | 28 |

According to Table 3, when the average particle size of alumina is controlled at about 1.40 μm and the average particle size of zirconia is controlled within the range of 0.4 μm-0.7 μm (when the particle size of zirconia is too small or too large, the flexural strength is adversely affected), the substrate has increased flexural strength.

Fig. 2 is an SEM image of the alumina sintered body of embodiment 22. Fig. 2 shows that zirconia and alumina are uniformly dispersed. Exemplary particle sizes are as labelled in the figure: 1.35 μm and 888 nm respectively.

The aforementioned alumina substrate was cladded with copper. The process includes:

(1) Cutting a copper foil into a suitable size;
(2) Pre-oxidising the surface of the copper foil to increase the bonding activity at the copper foil surface;
(3) Cleaning and chemically treating the surface of the alumina substrate to increase the activity of -OH groups at the surface;
(4) Copper-cladding the first surface: placing a copper sheet on the surface of the matrix. Metal copper is bonded to the matrix surface in a reducing atmosphere furnace (the furnace temperature is controlled at near the critical melting point of copper);
(5) Copper-cladding the second surface: placing the treated copper foil on the other side of the substrate. Metal copper is bonded to the second matrix surface in a reducing atmosphere furnace (the furnace temperature is slightly lower than the copper-cladding temperature of the first surface).

The bonding strength and high-temperature reliability of the copper-clad substrate were tested. The results are shown in Table 3. The testing methods are as follows:

(1) Determining the bonding strength between the copper plate and the zirconia-alumina composite substrate:
The bonding strength between the copper plate and the alumina substrate is determined by a peel test. The method is described below. Use a plier to peel the end portion of a pattern from the substrate, the end portion has a width of 5 mm and is part of the copper circuit pattern bonded to the alumina substrate. The bonded substrate is fixed to the workbench of a tensile tester. The aforementioned end portion of the pattern is fixed to the chuck of the tensile tester. Arrange the surface of the alumina substrate and the aforementioned end portion such that they form an angle of 90° (perpendicular). Then, operate the tensile tester; the peeled portion described above is stretched and moved upward via the chuck. The maximum peeling load at this time is measured. The bonding strength is calculated by dividing the maximum peeling load by the width (0.5 cm).
(2) Assessing high-temperature reliability of the zirconia-alumina composite DBC metal-ceramic substrate:
Carry out several cycles of heat cycle tests on the ZTA circuit board manufactured. Each cycle of the heat cycle test involves 15 minutes at -55°C and 15 minutes at 150°C. The interval time is <10s. After every 5 cycles, use an ultrasonic flaw detector to detect the bonding between the metal layer and the ceramic matrix layer. When the edge of the bonding layer show delamination of >2mm, it is determined that the DBC metal-ceramic substrate is no longer reliable.

Table 3

| Embodiments | Bonding strength after cladded with copper (Kdf/cm) | High-temperature reliability after cladded with copper (cycle) |
|---|---|---|
| Embodiment 1 | 11.3 | 30 |
| Embodiment 2 | 11.5 | 30 |
| Embodiment 3 | 12.4 | 35 |
| Embodiment 4 | 13.6 | 35 |
| Embodiment 5 | 14.8 | 45 |
| Embodiment 6 | 15.1 | 50 |
| Embodiment 7 | 15.6 | 60 |
| Embodiment 8 | 15.6 | 60 |
| Embodiment 9 | 15.7 | 60 |
| Embodiment 10 | 15.9 | 65 |
| Embodiment 11 | 16.1 | 65 |
| Embodiment 12 | 13.9 | 70 |
| Embodiment 13 | 13.8 | 70 |
| Embodiment 14 | 13.5 | 75 |
| Embodiment 15 | 13.1 | 80 |
| Embodiment 16 | 13.5 | 80 |
| Embodiment 17 | 15.4 | 55 |
| Embodiment 18 | 15.5 | 50 |
| Embodiment 19 | 15.3 | 55 |
| Embodiment 20 | 15.5 | 57 |
| Comparative Example | 10.2 | 25 |

It can be concluded from Table 3 that compared with the comparative example, the addition of zirconia in the present invention increases the bonding strength of the copper-clad ceramic substrate. However, as the amount of zirconia further increases, the bonding strength decreases by a certain extent. This is an important reason why in the present application, the sintered body preferably comprises 5% - 10% of a zirconium-containing compound (content thereof calculated with zirconia), 0.3% - 0.8% of a yttrium-containing compound (content thereof calculated with yttrium oxide), 0.4% - 0.6% of a silicon-containing compound (content thereof calculated with silicon oxide), 0.01% - 0.03% of a calcium-containing compound (content thereof calculated with calcium oxide), 0 - 0.03% of a magnesium-containing compound (content thereof calculated with magnesium oxide), and the balance being alumina.

**Claims**

1. A zirconia-alumina composite ceramic sintered body, **characterized in that** the zirconia-alumina composite ceramic sintered body comprises the following components in percentage by mass:
5%-15% of a zirconium-containing compound, content thereof calculated with zirconia; 0.3%-1% of a yttrium-containing compound, content thereof calculated with yttrium oxide; 0.04%-0.8% of a silicon-containing compound, content thereof calculated with silicon oxide; 0.01%-0.03% of a calcium-containing compound, content thereof calculated with calcium oxide; 0-0.03% of a magnesium-containing compound, content thereof calculated with magnesium oxide; and the balance being alumina; the zirconium-containing compound comprises zirconia.

2. The zirconia-alumina composite ceramic sintered body according to claim 1, **characterized in that** the zirconia-alumina composite ceramic sintered body comprises the following components in percentage by mass: 5%-10% of the zirconium-containing compound, content thereof calculated with zirconia; 0.3%-0.8% of the yttrium-containing compound, content thereof calculated with yttrium oxide; 0.4%-0.6% of the silicon-containing compound, content thereof calculated with silicon oxide; 0.01%-0.03% of the calcium-containing compound, content thereof calculated with calcium oxide; 0-0.03% of the magnesium-containing compound, content thereof calculated with magnesium oxide; and the balance being alumina.

3. The zirconia-alumina composite ceramic sintered body according to any one of claims 1-2, **characterized in that** in the zirconia-alumina composite ceramic sintered body, an average particle size D50 of the zirconium-containing compound is 0.1-1.5 times an average particle size D50 of the alumina.

4. The zirconia-alumina composite ceramic sintered body according to any one of claims 1-2, **characterized in that** in the zirconia-alumina composite ceramic sintered body, an average particle size D50 of the alumina is 0.8 $\mu$m-3 $\mu$m, a maximum particle size range of the alumina is 4 $\mu$m-10 $\mu$m.

5. The zirconia-alumina composite ceramic sintered body according to claim 4, **characterized in that** in the zirconia-alumina composite ceramic sintered body, an average particle size D50 of the alumina is 1.3 $\mu$m-2.5 $\mu$m, a maximum particle size range of the alumina is 4 $\mu$m-7 $\mu$m.

6. The zirconia-alumina composite ceramic sintered body according to any one of claims 1-2, **characterized in that** in the zirconia-alumina composite ceramic sintered body, an average particle size D50 of the zirconia is 0.2 $\mu$m-1.5 $\mu$m, a maximum particle size range of the zirconia is 1.0 $\mu$m - 2.5 $\mu$m.

7. The zirconia-alumina composite ceramic sintered body according to claim 6, **characterized in that** in the zirconia-alumina composite ceramic sintered body, the average particle size D50 of the zirconia is 0.4 $\mu$m-0.8 $\mu$m, the maximum particle size range of the zirconia is 1.2 $\mu$m-1.8 $\mu$m.

8. An alumina substrate comprising the zirconia-alumina composite ceramic sintered body according to any one of claims 1-2.

9. A method for preparing the alumina substrate according to claim 8, **characterized in that** it comprises the following steps:

(1) crushing raw material powder; pre-dispersing one part of alumina portion with a remaining portion of the raw material powder that has no alumina;
(2) calcinating the pre-dispersed powder of step (1) at 1300°C -1400°C for a holding time of 1-3 h, followed by crushing; then, adding the other part of the alumina for further mixing and dispersion to complete dispersion and mixing of the raw material powder;
(3) mixing the raw material powder obtained after the dispersion and mixing of step (2) with an organic binder and a dispersant;
(4) slurry degassing and aging;
(5) tape casting;
(6) sintering to obtain the alumina substrate.

**Patentansprüche**

1. Zirkonoxid-Aluminiumoxid-Verbundkeramik-Sinterkörper, **dadurch gekennzeichnet, dass** der Zirkonoxid-Aluminiumoxid-Verbundkeramik-Sinterkörper die folgenden Komponenten in den folgenden prozentualen Massenanteilen umfasst: 5 %-15 % einer zirkoniumhaltigen Verbindung, deren Gehalt mit Zirkonoxid berechnet ist; 0,3 %-1 % einer yttriumhaltigen Verbindung, deren Gehalt mit Yttriumoxid berechnet ist; 0,04 %-0,8 % einer siliciumhaltigen Verbindung, deren Gehalt mit Siliciumoxid berechnet ist; 0,01 %-0,03 % einer calciumhaltigen Verbindung, deren Gehalt mit Calciumoxid berechnet ist; 0-0,03 % einer magnesiumhaltigen Verbindung, deren Gehalt mit Magnesiumoxid berechnet ist; und wobei der Rest Aluminiumoxid ist; wobei die zirkoniumhaltige Verbindung Zirkonoxid umfasst.

2. Zirkonoxid-Aluminiumoxid-Verbundkeramik-Sinterkörper nach Anspruch 1, **dadurch gekennzeichnet, dass** der Zirkonoxid-Aluminiumoxid-Verbundkeramik-Sinterkörper die folgenden Komponenten in den folgenden prozentualen Massenanteilen umfasst: 5 %-10 % der zirkoniumhaltigen Verbindung, deren Gehalt mit Zirkonoxid berechnet ist; 0,3 %-0,8 % der yttriumhaltigen Verbindung, deren Gehalt mit Yttriumoxid berechnet ist; 0,4 %-0,6 % der siliciumhaltigen Verbindung, deren Gehalt mit Siliciumoxid berechnet ist; 0,01 %-0,03 % der calciumhaltigen Verbindung, deren Gehalt mit Calciumoxid berechnet ist; 0-0,03 % der magnesiumhaltigen Verbindung, deren Gehalt mit Magnesiumoxid berechnet ist; und wobei der Rest Aluminiumoxid ist.

3. Zirkonoxid-Aluminiumoxid-Verbundkeramik-Sinterkörper nach einem der Ansprüche 1-2, **dadurch gekennzeichnet, dass** eine durchschnittliche Partikelgröße D50 der zirkoniumhaltigen Verbindung im Zirkonoxid-Aluminiumoxid-Verbundkeramik-Sinterkörper ein 0,1-1,5-Faches einer durchschnittlichen Partikelgröße D50 des Aluminiumoxids ist.

4. Zirkonoxid-Aluminiumoxid-Verbundkeramik-Sinterkörper nach einem der Ansprüche 1-2, **dadurch gekennzeichnet, dass** eine durchschnittliche Partikelgröße D50 des Aluminiumoxids im Zirkonoxid-Aluminiumoxid-Verbundkeramik-Sinterkörper 0,8 $\mu$m-3 $\mu$m beträgt, eine maximale Partikelgröße des Aluminiumoxids im Bereich von 4 $\mu$m-10 $\mu$m liegt.

5. Zirkonoxid-Aluminiumoxid-Verbundkeramik-Sinterkörper nach Anspruch 4, **dadurch gekennzeichnet, dass** eine durchschnittliche Partikelgröße D50 des Aluminiumoxids im Zirkonoxid-Aluminiumoxid-Verbundkeramik-Sinterkörper 1,3 $\mu$m-2,5 $\mu$m beträgt, eine maximale Partikelgröße des Aluminiumoxids im Bereich von 4 $\mu$m-7 $\mu$m liegt.

6. Zirkonoxid-Aluminiumoxid-Verbundkeramik-Sinterkörper nach einem der Ansprüche 1-2, **dadurch gekennzeichnet, dass** eine durchschnittliche Partikelgröße D50 des Zirkonoxids im Zirkonoxid-Aluminiumoxid-Verbundkeramik-Sinterkörper 0,2 $\mu$m-1,5 $\mu$m beträgt, eine maximale Partikelgröße des Zirkonoxids im Bereich von 1,0 $\mu$m-2,5 $\mu$m liegt.

7. Zirkonoxid-Aluminiumoxid-Verbundkeramik-Sinterkörper nach Anspruch 6, **dadurch gekennzeichnet, dass** die durchschnittliche Partikelgröße D50 des Zirkonoxids im Zirkonoxid-Aluminiumoxid-Verbundkeramik-Sinterkörper 0,4 $\mu$m-0,8 $\mu$m beträgt, die maximale Partikelgröße des Zirkonoxids im Bereich von 1,2 $\mu$m-1,8 $\mu$m liegt.

8. Aluminiumoxid-Substrat, umfassend den Zirkonoxid-Aluminiumoxid-Verbundkeramik-Sinterkörper nach einem der Ansprüche 1-2.

9. Verfahren zum Herstellen des Aluminiumoxid-Substrats nach Anspruch 8, **dadurch gekennzeichnet, dass** es die folgenden Schritte umfasst:

(1) Zerkleinern von Rohmaterialpulver; Vordispergieren eines Teils des Aluminiumoxidanteils mit einem verbleibenden Anteil des Rohmaterialpulvers, das kein Aluminiumoxid aufweist;
(2) Calcinieren des vordispergierten Pulvers aus Schritt (1) bei 1300 °C-1400 °C für eine Verweildauer von 1 bis 3 h, gefolgt von Zerkleinern; danach Zugeben des anderen Teils des Aluminiumoxids zum weiteren Mischen und Dispergieren, um das Dispergieren und Mischen des Rohmaterialpulvers abzuschließen;
(3) Mischen des Rohmaterialpulvers, das nach dem Dispergieren und Mischen von Schritt (2) erhalten wurde, mit einem organischen Bindemittel und einem Dispersionsmittel;
(4) Schlammentgasen und Altern;
(5) Foliengießen;
(6) Sintern, um das Aluminiumoxid-Substrat zu erhalten.

## Revendications

1. Corps fritté en céramique composite de zircone-alumine, **caractérisé en ce que** le corps fritté en céramique composite de zircone-alumine comprend les composants suivants en pourcentage en masse : 5 % à 15 % d'un composé contenant du zirconium, la teneur en celui-ci étant calculée avec de la zircone ; 0,3 % à 1 % d'un composé contenant de l'yttrium, la teneur en celui-ci étant calculée avec de l'oxyde d'yttrium ; 0,04 % à 0,8 % d'un composé contenant du silicium, la teneur en celui-ci étant calculée avec de l'oxyde de silicium ; 0,01 % à 0,03 % d'un composé contenant du calcium, la teneur en celui-ci étant calculée avec de l'oxyde de calcium ; 0 à 0,03 % d'un composé contenant du magnésium, la teneur en celui-ci étant calculée avec de l'oxyde de magnésium ; et l'équilibre étant de l'alumine ; le composé contenant du zirconium comprend de la zircone.

2. Corps fritté en céramique composite de zircone-alumine selon la revendication 1, **caractérisé en ce que** le corps fritté en céramique composite de zircone-alumine comprend les composants suivants en pourcentage en masse :

5 % à 10 % du composé contenant du zirconium, la teneur en celui-ci étant calculée avec de la zircone ; 0,3 % à 0,8 % du composé contenant de l'yttrium, la teneur en celui-ci étant calculée avec de l'oxyde d'yttrium ; 0,4 % à 0,6 % du composé contenant du silicium, la teneur en celui-ci étant calculée avec de l'oxyde de silicium ; 0,01 % à 0,03 % du composé contenant du calcium, la teneur en celui-ci étant calculée avec de l'oxyde de calcium ; 0 à 0,03 % du composé contenant du magnésium, la teneur en celui-ci étant calculée avec de l'oxyde de magnésium ; et l'équilibre étant de l'alumine.

**3.** Corps fritté en céramique composite de zircone-alumine selon l'une quelconque des revendications 1 et 2, **caractérisé en ce que** dans le corps fritté en céramique composite de zircone-alumine, une taille particulaire moyenne D50 du composé contenant du zirconium est 0,1 à 1,5 fois une taille particulaire moyenne D50 de l'alumine.

**4.** Corps fritté en céramique composite de zircone-alumine selon l'une quelconque des revendications 1 et 2, **caractérisé en ce que** dans le corps fritté en céramique composite de zircone-alumine, une taille particulaire moyenne D50 de l'alumine est de 0,8 $\mu$m à 3 $\mu$m, une plage de taille particulaire maximale de l'alumine est de 4 $\mu$m à 10 $\mu$m.

**5.** Corps fritté en céramique composite de zircone-alumine selon la revendication 4, **caractérisé en ce que** dans le corps fritté en céramique composite de zircone-alumine, une taille particulaire moyenne D50 de l'alumine est de 1,3 $\mu$m à 2,5 $\mu$m, une plage de taille particulaire maximale de l'alumine est de 4 $\mu$m à 7 $\mu$m.

**6.** Corps fritté en céramique composite de zircone-alumine selon l'une quelconque des revendications 1 et 2, **caractérisé en ce que** dans le corps fritté en céramique composite de zircone-alumine, une taille particulaire moyenne D50 de la zircone est de 0,2 $\mu$m à 1,5 $\mu$m, une plage de taille particulaire maximale de la zircone est de 1,0 $\mu$m à 2,5 $\mu$m.

**7.** Corps fritté en céramique composite de zircone-alumine selon la revendication 6, **caractérisé en ce que** dans le corps fritté en céramique composite de zircone-alumine, la taille particulaire moyenne D50 de la zircone est de 0,4 $\mu$m à 0,8 $\mu$m, la plage de taille particulaire maximale de la zircone est de 1,2 $\mu$m à 1,8 $\mu$m.

**8.** Substrat en alumine comprenant le corps fritté en céramique composite de zircone-alumine selon l'une quelconque des revendications 1 et 2.

**9.** Procédé de préparation du substrat en alumine selon la revendication 8, **caractérisé en ce qu'**il comprend les étapes suivantes :

   (1) écraser de la matière première en poudre ; disperser au préalable une partie de portion d'alumine avec une portion restante de la matière première en poudre qui n'a pas d'alumine ;
   (2) calciner la poudre dispersée au préalable de l'étape (1) à 1300 °C à 1400 °C pendant une durée de maintien de 1 à 3 h, suivi d'un écrasement ; puis, ajouter l'autre partie de l'alumine pour mélange et dispersion supplémentaires pour achever la dispersion et le mélange de la matière première en poudre ;
   (3) mélanger la matière première en poudre obtenue après la dispersion et le mélange de l'étape (2) avec un liant organique et un dispersant ;
   (4) dégazer et vieillir la barbotine ;
   (5) couler une bande ;
   (6) fritter pour obtenir le substrat en alumine.

FIG. 1

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201080015347
- CN 201380056024
- DE 102004012231
- EP 3315476 A1
- WO 2014103465 A1
- EP 2980042 A1